# EUROPEAN PATENT SPECIFICATION

(11) **EP 3 564 941 B1**
(45) Date of publication and mention of the grant of the patent: **13.10.2021**
(21) Application number: 16925452.1
(22) Date of filing: 30.12.2016
(51) Int. Cl.: G09G 3/36, G09G 3/3266

(54) **GOA CIRCUIT**
GOA-SCHALTUNG
CIRCUIT GOA

(30) Priority: 27.12.2016 CN 201611229691
(43) Date of publication of application: 06.11.2019
(73) Proprietor: Wuhan China Star Optoelectronics Technology Co., Ltd., Wuhan, Hubei 430079, (CN)
(72) Inventor: LI, Yafeng, Wuhan, Hubei 430070 (CN)
(74) Representative: Murgitroyd & Company
(86) International application number: PCT/CN2016/113324
(87) International publication number: WO 2018/119967

(56) References cited:
- CN-A- 101 345 089
- CN-A- 104 851 383
- CN-A- 105 280 134
- CN-A- 105 637 590
- KR-B1- 101 549 248
- US-A1- 2012 139 599
- US-A1- 2014 022 228
- US-A1- 2016 358 564

## Description

### BACKGROUND OF THE INVENTION

### Field of the Invention

The present invention relates to the field of display, and in particular to a gate driver on array (GOA) circuit.

### The Related Arts

As the liquid crystal display (LCD) shows the advantages of high display quality, low power-consumption, thinness, and wide applications, the LCD is widely used in various devices, such as, liquid crystal TV, mobile phones, PDA, digital camera, PC monitors or notebook PC screens, becomes the leading display technology. The low temperature polysilicon (LTPS) is an LCD technology widely used in small or medium-sized electronic products. The LTPS LCD provides the advantages of high resolution, fast response and high aperture rate.

The gate driver on array (GOA) technology is the array substrate column drive technology, by using the array substrate process for the LCD panel to manufacture the driver circuit for the gate scan line on the array substrate to achieve driving of the gates by line-by-line scanning. Correspondingly, the integrated circuit (IC) on the peripheral area of the substrate also attracts attention and much research is taken to explore the system-on-panel (SOP) technology, which gradually takes shape in application.

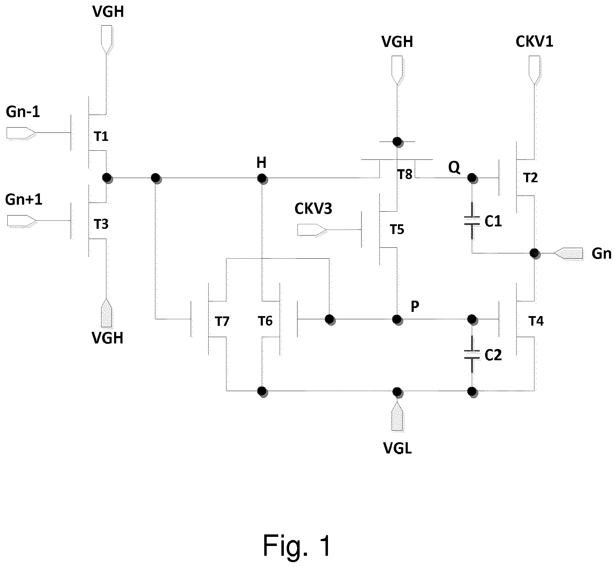

Refer to Figure 1. A known GOA circuit is applicable to LTPS panel, and mainly comprises: eight thin film transistors (TFT) and two capacitors. The known GOA circuit comprises: a plurality of cascade GOA units, wherein the n-th GOA unit for outputting n-th scan horizontal scan signal comprising: a TFT T1, having a gate connected to the signal output Gn+1 of the (n+1)th GOA unit, a source and a drain connected respectively to the node H and the constant high voltage VGH; a TFT T2, having a gate connected to the node Q, a source and a drain connected respectively to the signal output Gn of the n-th GOA unit and the input clock signal CKV1; a TFT T3, having a gate connected to the signal output Gn-1 of the (n-1)th GOA unit, a source and a drain connected respectively to the node H and the constant high voltage VGH; a TFT T4, having a gate connected to the node P, a source and a drain connected respectively to the node P and the constant low voltage VGL; a TFT T5, having a gate connected to the input clock signal CKV3, a source and a drain connected respectively to the node P and the constant high voltage VGH; a TFT T6, having a gate connected to the node P, a source and a drain connected respectively to the node H and the constant low voltage VGL; a TFT T7, having a gate connected to the node H, a source and a drain connected respectively to the node P and the constant low voltage VGL; a TFT T8, having a gate connected to the constant high voltage VGH, a source and a drain connected respectively to the node H and the node Q; a capacitor Q1, having two ends connected respectively to the node Q and the signal output Gn; and a capacitor C2, having two ends connected respectively to the node P and the constant low voltage VGL. The node Q is the node controlling the gate driving signal output, and the node P is the stability node maintaining the Q and Gn at low voltage.

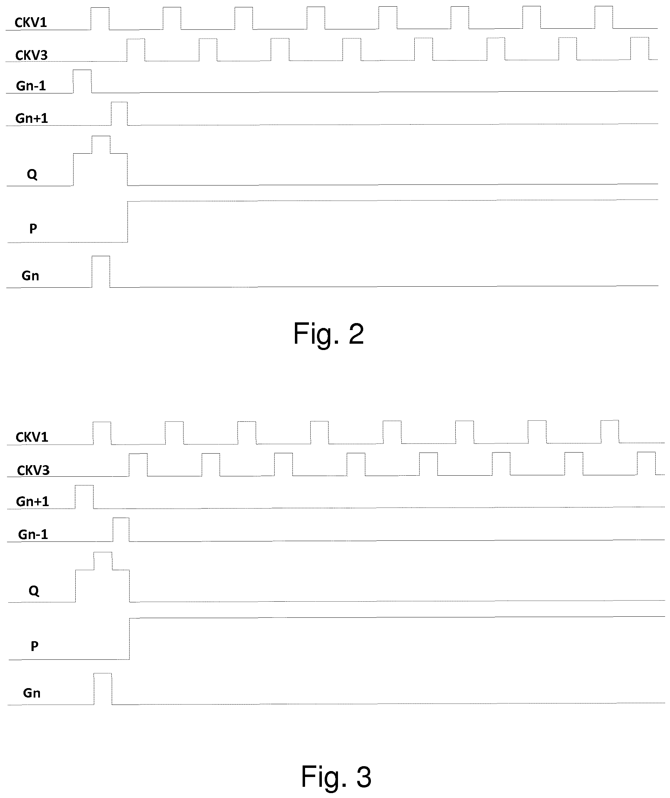

Refer to Figure 2, which shows a schematic view of timing sequence of forward scanning in the GOA circuit of Figure 1. Also referring to Figure 1, the forward scanning of the circuit is described as follows:
Stage 1, pre-charging: Gn-1 is at high voltage, T1 is conductive, node H is pre-charged, T8 stays in conductive state, and node Q is pre-charged.
Stage 2, Gn outputting high voltage: in Stage 1, node Q is pre-charged and C1 maintains the charges, T2 is conductive, CKV1 outputs high voltage to Gn. Stage 3, Gn outputting low voltage: C1 maintains the high voltage of node Q, and the low voltage of CKV1 lowers the Gn; at the same time, Gn+1 is at high voltage, T3 is conducive, and node Q is maintained at high voltage.
Stage 4, node Q lowered to VGL: when CKV3 is at high voltage, T5 is conductive, node P is pulled up, T6 is conductive and node Q is lowered.
Stage 5, node Q and Gn maintained at low voltage: when node Q becomes at low voltage, T7 is cut-off. When CKV3 is at high voltage, node P is charged to high voltage, T4 and T6 are conductive, node Q and Gn are maintained at low voltage.

Refer to Figure 3, which shows a schematic view of timing sequence of backward scanning in the GOA circuit of Figure 1. Also referring to Figure 1, the backward scanning of the circuit is described as follows:
Stage 1, pre-charging: Gn+1 is at high voltage, T3 is conductive, node H is pre-charged, T8 stays in conductive state, and node Q is pre-charged.
Stage 2, Gn outputting high voltage: in Stage 1, node Q is pre-charged and C1 maintains the charges, T2 is conductive, CKV1 outputs high voltage to Gn.
Stage 3, Gn outputting low voltage: C1 maintains the high voltage of node Q, and the low voltage of CKV1 lowers the Gn; at the same time, Gn-1 is at high voltage, T1 is conducive, and node Q is maintained at high voltage.
Stage 4, node Q lowered to VGL: when CKV3 is at high voltage, T5 is conductive, node P is pulled up, T6 is conductive and node Q is lowered.
Stage 5, node Q and Gn maintained at low voltage: when node Q becomes at low voltage, T7 is cut-off. When CKV3 is at high voltage, node P is charged to high voltage, T4 and T6 are conductive, node Q and Gn are maintained at low voltage.

In the known GOA circuit in Figure 1, for the introducing points, i.e., the node Q and the node H, the node Q is self-raised by C1 when Gn outputs the high voltage. The detailed waveform is shown in Figure 2 and Figure 3. To prevent the high voltage of the node Q from imposing onto the node H to cause stress on the TFT T7 during self-raising by C1, the TFT T8 is added between the node Q and the node H, with the gate of TFT T8 connected to VGH. As such, T8 in the GOA circuit always stays conductive. At the maintained low level stage, when the node H leaks current, the effect will be propagated to the node Q and T2 will also leak current to some extent, leading to unstable output Gn, which is an issue must be addressed. US2012/139599A1 is a related prior art for this field. More particularly, US2012/139599A1 discloses a multiplex driving circuit for use with an LCD panel. CN105280134A is a related prior art for this field. More particularly, CN105280134A discloses a shift register circuit and a method of operating the same. US2014/022228A1 is a related prior art for this field. More particularly, US2014/022228A1 discloses a gate driver and a display device including the gate driver. US2016/358564A1 is a related prior art for this field. More particularly, US2016/358564A1 discloses scan driving circuit for driving scan lines which are connected in series, including a pull-down controlling module, a pull-down module, a reset-controlling module, a resetting module, a downward-transmitting module, a first bootstrap capacitor, a constant low voltage level source, and a constant high voltage level source.

### SUMMARY OF THE INVENTION

The object of the present invention is to provide a display device comprising a GOA circuit, based on the known GOA circuit, to solve the issue of unstable output Gn in the known GOA circuit.

To achieve the above object, the present invention provides a display device as set out in claim 1.

According to a preferred embodiment of the present invention, both the first clock signal and the second clock signal are rectangular waves having a duty ratio of 0.25, and the waveforms between the first clock signal and the second clock signal differ by a half cycle.

According to a preferred embodiment of the present invention, for the first GOA unit in the cascade, during forward scanning, the first start signal is at high voltage; when the first start signal becomes low voltage, the output signal of n-th GOA unit becomes high voltage.

According to a preferred embodiment of the present invention, for the last GOA unit in the cascade, during backward scanning, the second start signal is at high voltage; when the second start signal becomes low voltage, the output signal of n-th GOA unit becomes high voltage.

According to a preferred embodiment of the present invention, for the first GOA unit in the cascade, during forward scanning, when the first start signal is at high voltage, the third start signal is high voltage.

According to a preferred embodiment of the present invention, for the last GOA unit in the cascade, during backward scanning, when the second start signal is at high voltage, the fourth start signal is high voltage.

According to a preferred embodiment of the present invention, the GOA circuit is for low temperature polysilicon (LTPS) panel.

According to a preferred embodiment of the present invention, the GOA circuit is for organic light-emitting diode (OLED) panel.

Compared to the known techniques, the present invention provides the following advantages: the GOA circuit of the present invention not only provides the function of known GOA circuit to prevent the stress on the TFT T7, but it can also prevent output Gn from instability.

### BRIEF DESCRIPTION OF THE DRAWINGS

To make the technical solution of the embodiments according to the present invention, a brief description of the drawings that are necessary for the illustration of the embodiments will be given as follows. Apparently, the drawings described below show only example embodiments of the present invention and for those having ordinary skills in the art, other drawings may be easily obtained from these drawings without paying any creative effort. In the drawings:
Figure 1 is a schematic view showing a known GOA circuit;
Figure 2 is a schematic view showing the forward scanning timing for the GOA circuit of Figure 1;
Figure 3 is a schematic view showing the backward scanning timing for the GOA circuit of Figure 1;
Figures 4 is a schematic view showing the GOA circuit provided by an embodiment of the present invention;
Figure 5 is a schematic view showing the forward scanning timing for GOA circuit of Figure 4;
**[0001]** Figure 6 is a schematic view showing the backward scanning timing for GOA circuit of Figure 4.

### DETAILED DESCRIPTION OF THE PREFERRED EMBODIMENTS

To further explain the technical means and effect of the present invention, the following refers to embodiments and drawings for detailed description.

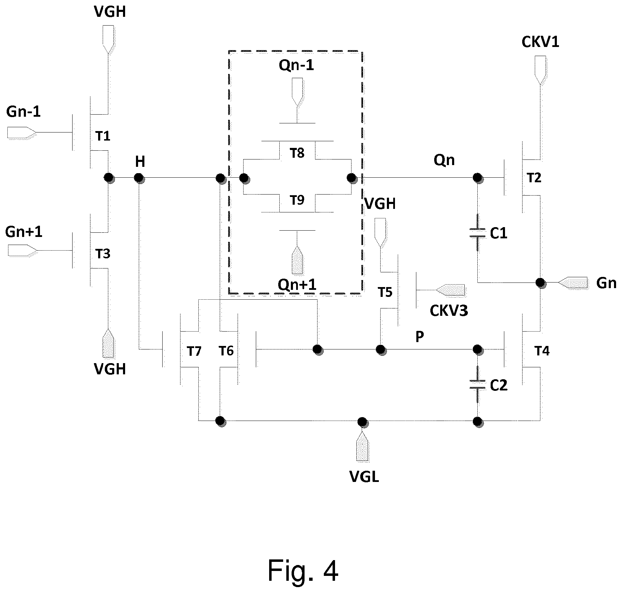

Refer to Figure 4. The present invention provides a GOA circuit, applicable to an LTPS panel. The GOA circuit comprises: a plurality of cascade GOA units, for a positive integer n, the n-th GOA unit comprising: a first thin film transistor (TFT) T1, when the n-th GOA unit not the first GOA unit in the cascade, having a gate connected to a signal output Gn-1 of the (n-1)th GOA unit, and having a source and a drain connected respectively to a first node H and a constant high voltage VGH; a second TFT T2, having a gate connected to a second node Qn of n-th GOA unit, a source and a drain connected respectively to the output signal Gn of n-th GOA unit and inputted a first clock signal CKV1; a third TFT T3, when the n-th GOA unit not the last GOA unit in the cascade, having a gate connected to a signal output Gn+1 of (n+1)th GOA unit, a source and a drain connected respectively to the first node H and the constant high voltage VGH; a fourth TFT T4, having a gate connected to a third node P, a source and a drain connected respectively to the output signal Gn of n-th GOA unit and a constant low voltage VGL; a fifth TFT T5, having a gate connected to a second clock signal CKV3, a source and a drain connected respectively to the third node P and the constant high voltage VGH; a sixth TFT T6, having a gate connected to the third node P, a source and a drain connected respectively to the first node H and the constant low voltage VGL; a seventh TFT, having a gate connected to the first node H, a source and a drain connected respectively to the third node P and the constant low voltage VGL; an eighth TFT T8, when the n-th GOA unit not the first GOA unit in the cascade, having a gate connected to the second node Qn-1of (n-1)th GOA unit, a source and a drain connected respectively to the first node H and the second node Qn of n-th GOA unit; a ninth TFT T9, when the n-th GOA unit not the last GOA unit in the cascade, having a gate connected to the second node Qn-1 of (n+1)th GOA unit, a source and a drain connected respectively to the first node H and the second node Qn of n-th GOA unit; a first capacitor C1, having two ends connected respectively to the second node Qn of n-th GOA unit and the output signal Gn of n-th GOA unit; and a second capacitor C2, having e two ends connected respectively to the third node P and the constant low voltage VGL.

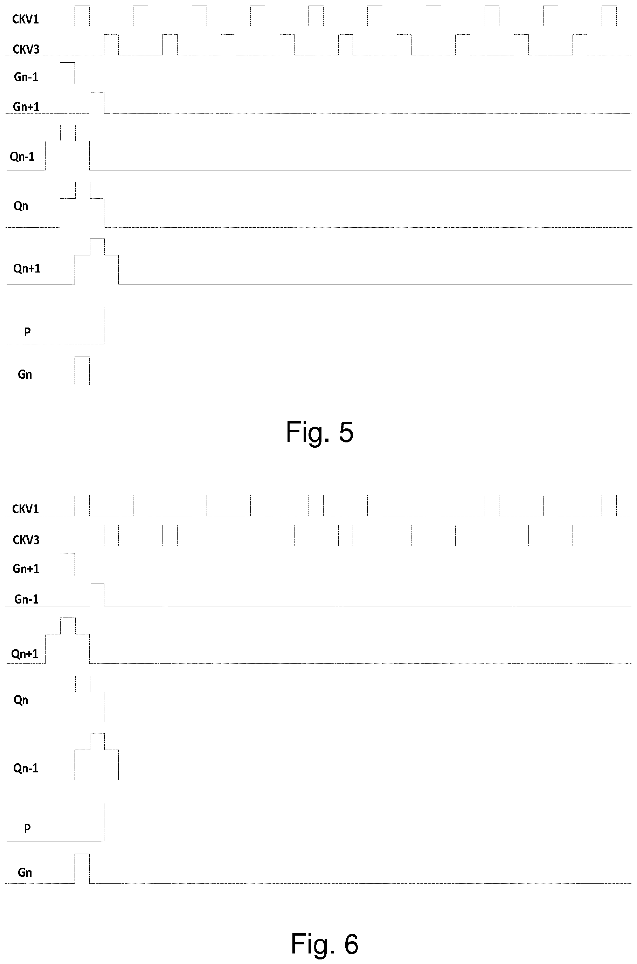

Refer to Figure 5, which shows a schematic view of timing sequence of forward scanning in the GOA circuit of Figure 4. Also referring to Figure 4, the forward scanning of the circuit is described as follows:
Stage 1, pre-charging: Gn-1 is at high voltage, T1 is conductive, the node H is pre-charged, at this point Qn-1 is at high voltage, T8 stays in conductive state, and the node Qn is pre-charged.
Stage 2, Gn outputting high voltage: in Stage 1, the node Qn is pre-charged and C1 maintains the charges, T2 is conductive, CKV1 outputs high voltage to Gn.
Stage 3, Gn outputting low voltage: C1 maintains the high voltage of node Qn, and the low voltage of CKV1 lowers the Gn; at the same time, Gn+1 is at high voltage, T3 is conducive, and node Qn is maintained at high voltage.
Stage 4, node Qn lowered to VGL: when CKV3 is at high voltage, T5 is conductive, node P is pulled up, T6 is conductive and node Qn is lowered.
Stage 5, node Qn and Gn maintained at low voltage: when node Qn becomes at low voltage, T7 is cut-off. When CKV3 is at high voltage, node P is charged to high voltage, T4 and T6 are conductive, node Qn and Gn are maintained at low voltage.

As shown in Figure 5, both the clock signal CKV1 and the clock signal CKV3 are rectangular waves having a duty ratio of 0.25, and the waveforms between the clock signal CKV1 and the clock signal CKV3 differ by a half cycle.

The present invention uses input start signals to replace the missing signal input for the first and the last GOA units in the cascade. During forward scanning, when n is 1, i.e., in the first GOA unit, the gate of T1 is connected to a first start signal, initially at high voltage; when the start signal becomes low voltage, the output signal Gn becomes high voltage.

In the first GOA unit, during forward scanning, when the first start signal is at high voltage, the third start signal inputted to the gate of T8 is at high voltage.

Refer to Figure 6, which shows a schematic view of timing sequence of backward scanning in the GOA circuit of Figure 4. Also referring to Figure 4, the backward scanning of the circuit is described as follows:
Stage 1, pre-charging: Gn+1 is at high voltage, T3 is conductive, the node H is pre-charged, at this point, Qn+1 is at high voltage,T9 stays in conductive state, and node Qn is pre-charged.
Stage 2, Gn outputting high voltage: in Stage 1, the node Qn is pre-charged and C1 maintains the charges, T2 is conductive, CKV1 outputs high voltage to Gn.
Stage 3, Gn outputting low voltage: C1 maintains the high voltage of node Qn, and the low voltage of CKV1 lowers the Gn; at the same time, Gn-1 is at high voltage, T1 is conducive, and node Qn is maintained at high voltage.
Stage 4, node Qn lowered to VGL: when CKV3 is at high voltage, T5 is conductive, node P is pulled up, T6 is conductive and node Qn is lowered.
Stage 5, node Qn and Gn maintained at low voltage: when node Qn becomes at low voltage, T7 is cut-off. When CKV3 is at high voltage, node P is charged to high voltage, T4 and T6 are conductive, node Qn and Gn are maintained at low voltage.

As shown in Figure 6, both the clock signal CKV1 and the clock signal CKV3 are rectangular waves having a duty ratio of 0.25, and the waveforms between the clock signal CKV1 and the clock signal CKV3 differ by a half cycle.

The present invention uses input start signals to replace the missing signal input for the first and the last GOA units in the cascade. During forward scanning, when n-th GOA unit is the last GOA unit in the cascade, the gate of T3 is connected to a second start signal, initially at high voltage; when the start signal becomes low voltage, the output signal Gn becomes high voltage.

In the last GOA unit, during backward scanning, when the second start signal is at high voltage, the fourth start signal inputted to the gate of T9 is at high voltage.

As shown in dashed box of Figure 4, based on the known GOA circuit, the present invention uses T8 and T9 connected in parallel between node H and node Qn for conduction. The gate of T8 is connected to Qn-1 (the output signal of the previous GOA unit), and the gate of T9 is connected to Qn+1 (the output signal of the next GOA unit). Because Qn is at low voltage most of the time other than when Gn outputs high voltage, this new connection can provide the function of the known GOA circuit to prevent the stress on TFT T7 caused by the imposition from the Qn on the node H when Qn self-raised. Moreover, the new connection can also prevent, during the low voltage maintenance stage, the current leakage at node H from propagating to Qn. At some extent, T2 leaks current and causes the output Gn unstable.

The GOA circuit of the present invention can be applied and potentially applied to the following: 1, integrated gate driver circuit on the array substrate of LCD; 2, the gate driving for mobile phones, displays and TVs; 3, advanced technology for LCD and OLED industry; and 4, the circuit stability of the present invention applicable to high-resolution panel.

In summary, the GOA circuit of the present invention not only can provide the function of known GOA circuit to prevent TFT T7 from stress, but also prevent output signal Gn from instability.

It should be noted that in the present disclosure the terms, such as, first, second are only for distinguishing an entity or operation from another entity or operation, and does not imply any specific relation or order between the entities or operations. Also, the terms "comprise", "include", and other similar variations, do not exclude the inclusion of other non-listed elements. Without further restrictions, the expression "comprises a..." does not exclude other identical elements from presence besides the listed elements.

## Claims

1. A display device comprising:
a gate driver on array, GOA circuit, said GOA circuit comprising a plurality of cascade GOA units,
a circuit adapted to supply a constant high voltage (VGH) and a constant low voltage (VGL), and
a circuit adapted to supply a first clock signal (CKV1), a second clock signal (CKV3), and first to fourth start signals,
wherein, for a positive integer n, **characterized in that** the n-th GOA unit comprises:
a first thin film transistor, TFT (T1), having a source and a drain connected respectively to a first node (H) and the constant high voltage (VGH), when the n-th GOA unit is not the first GOA unit in the cascade, having a gate connected to a signal output (Gn-1) of the (n-1)th GOA unit; otherwise, the gate connected to the first start signal;
a third TFT (T3), having a source and a drain connected respectively to the first node (H) and the constant high voltage (VGH), when the n-th GOA unit is not the last GOA unit in the cascade, having a gate connected to a signal output (Gn+1) of the (n+1)th GOA unit; otherwise, the gate connected to the second start signal;
a seventh TFT (T7), having a gate connected to the first node (H), a source and a drain connected respectively to a third node (P) and the constant low voltage (VGL);
a sixth TFT (T6), having a gate connected to the third node (P), a source and a drain connected respectively to the first node (H) and the constant low voltage (VGL);
a fifth TFT (T5), having a gate connected to a second clock terminal adapted to receive the second clock signal (CKV3), a source and a drain connected respectively to the third node (P) and the constant high voltage (VGH);
a fourth TFT (T4), having a gate connected to the third node (P), a source and a drain connected respectively to a signal output (Gn) of the n-th GOA unit and the constant low voltage (VGL);
a second TFT (T2), having a gate connected to a second node (Qn) of the n-th GOA unit, a source and a drain connected respectively to signal output (Gn) of n-th GOA unit and a first clock terminal adapted to receive the first clock signal (CKV1);
an eighth TFT (T8), having a source and a drain connected respectively to the first node (H) and the second node (Qn) of the n-th GOA unit, when the n-th GOA unit is not the first GOA unit in the cascade, having a gate connected to the second node (Qn) of (n-1)th GOA unit; otherwise, the gate connected to the third start signal;
a ninth TFT (T9), having a source and a drain connected respectively to the first node (H) and the second node (Qn) of n-th GOA unit, when the n-th GOA unit is not the last GOA unit in the cascade, having a gate connected to the second node (Qn) of (n+1)th GOA unit; otherwise, the gate connected to the fourth start signal;
a first capacitor (C1), having two ends connected respectively to the second node (Qn) of n-th GOA unit and the signal output (Gn) of n-th GOA unit;
a second capacitor (C2), having two ends connected respectively to the third node (P) and the constant low voltage (VGL);
a terminal adapted to receive the constant high voltage (VGH); and
a terminal adapted to receive the constant low voltage (VGL).

2. The display device as claimed in Claim 1, **characterized in that** the first clock signal (CKV1) and the second clock signal (CKV3) are rectangular waves having a duty ratio of 0.25, and the waveforms between the first clock signal (CKV1) and the second clock signal (CKV3) differ by a half cycle.

3. The display device as claimed in Claim 1 or 2, **characterized in that** for the first GOA unit in the cascade, during forward scanning, the first start signal is at high voltage; when the first start signal becomes low voltage, the output signal (Gn) of n-th GOA unit becomes high voltage.

4. The display device as claimed in any one of Claims 1 to 3, **characterized in that** for the last GOA unit in the cascade, during backward scanning, the second start signal is at high voltage; when the second start signal becomes low voltage, the output signal (Gn) of n-th GOA unit becomes high voltage.

5. The display device as claimed in any one of Claims 1 to 4, **characterized in that** for the first GOA unit in the cascade, during forward scanning, when the first start signal is at high voltage, the third start signal is high voltage.

6. The display device as claimed in any one of Claims 1 to 5, **characterized in that** for the last GOA unit in the cascade, during backward scanning, when the second start signal is at high voltage, the fourth start signal is high voltage.

7. The display device as claimed in any one of Claims 1 to 6, **characterized in that** the GOA circuit is for low temperature polysilicon, LTPS, panel.

8. The display device as claimed in any one of Claims 1 to 7, **characterized in that** the GOA circuit is for organic light-emitting diode, OLED, panel.

## Patentansprüche

1. Eine Anzeigevorrichtung, die Folgendes beinhaltet:
eine Gate-Driver-on-Array-Schaltung, GOA-Schaltung, wobei die GOA-Schaltung eine Vielzahl von kaskadierten GOA-Einheiten beinhaltet,
eine Schaltung, die angepasst ist, um eine konstante Hochspannung (VGH) und eine konstante Niederspannung (VGL) zu liefern, und
eine Schaltung, die angepasst ist, um ein erstes Taktsignal (CKV1), ein zweites Taktsignal (CKV3) und ein erstes bis viertes Startsignal zu liefern, wobei, für eine positive ganze Zahl n, **dadurch gekennzeichnet, dass** die nte GOA-Einheit Folgendes beinhaltet:
einen ersten Dünnschichttransistor, TFT (T1), der eine Source und einen Drain aufweist, die mit einem ersten Knoten (H) bzw. der konstanten Hochspannung (VGH) verbunden sind, wenn die nte GOA-Einheit nicht die erste GOA-Einheit in der Kaskade ist, und ein Gate aufweist, das mit einer Signalausgabe (Gn-1) der (n-1)ten GOA-Einheit verbunden ist; wobei das Gate andernfalls mit dem ersten Startsignal verbunden ist;
einen dritten TFT (T3), der eine Source und einen Drain aufweist, die mit dem ersten Knoten (H) bzw. der konstanten Hochspannung (VGH) verbunden sind, wenn die nte GOA-Einheit nicht die letzte GOA-Einheit in der Kaskade ist, und ein Gate aufweist, das mit einer Signalausgabe (Gn+1) der (n+1)ten GOA-Einheit verbunden ist; wobei das Gate andernfalls mit dem zweiten Startsignal verbunden ist;
einen siebten TFT (T7), der ein Gate, das mit dem ersten Knoten (H) verbunden ist, eine Source und einen Drain, die mit einem dritten Knoten (P) bzw. der konstanten Niederspannung (VGL) verbunden sind, aufweist;
einen sechsten TFT (T6), der ein Gate, das mit dem dritten Knoten (P) verbunden ist, eine Source und einen Drain, die mit dem ersten Knoten (H) bzw. der konstanten Niederspannung (VGL) verbunden sind, aufweist;
einen fünften TFT (T5), der ein Gate, das mit einem zweiten Taktanschluss, der angepasst ist, um das zweite Taktsignal (CKV3) zu empfangen, verbunden ist, eine Source und einen Drain, die mit dem dritten Knoten (P) bzw. der konstanten Hochspannung (VGH) verbunden sind, aufweist;
einen vierten TFT (T4), der ein Gate, das mit dem dritten Knoten (P) verbunden ist, eine Source und einen Drain, die mit einer Signalausgabe (Gn) der nten GOA-Einheit bzw. der konstanten Niederspannung (VGL) verbunden sind, aufweist;
einen zweiten TFT (T2), der ein Gate, das mit einem zweiten Knoten (Qn) der nten GOA-Einheit verbunden ist, eine Source und einen Drain, die mit der Signalausgabe (Gn) der nten GOA-Einheit bzw. einem ersten Taktanschluss, der angepasst ist, um das erste Taktsignal (CKV1) zu empfangen, verbunden sind, aufweist;
einen achten TFT (T8), der eine Source und einen Drain aufweist, die mit dem ersten Knoten (H) bzw. dem zweiten Knoten (Qn) der nten GOA-Einheit verbunden sind, wenn die nte GOA-Einheit nicht die erste GOA-Einheit in der Kaskade ist, und ein Gate aufweist, das mit dem zweiten Knoten (Qn) der (n-1)ten GOA-Einheit verbunden ist;
wobei das Gate andernfalls mit dem dritten Startsignal verbunden ist;
einen neunten TFT (T9), der eine Source und einen Drain aufweist, die mit dem ersten Knoten (H) bzw. dem zweiten Knoten (Qn) der nten GOA-Einheit verbunden sind, wenn die nte GOA-Einheit nicht die letzte GOA-Einheit in der Kaskade ist, und ein Gate aufweist, das mit dem zweiten Knoten (Qn) der (n+1)ten GOA-Einheit verbunden ist;
wobei das Gate andernfalls mit dem vierten Startsignal verbunden ist;
einen ersten Kondensator (C1), der zwei Enden aufweist, die mit dem zweiten Knoten (Qn) der nten GOA-Einheit bzw. der Signalausgabe (Gn) der nten GOA-Einheit verbunden sind;
einen zweiten Kondensator (C2), der zwei Enden aufweist, die mit dem dritten Knoten (P) bzw. der konstanten Niederspannung (VGL) verbunden sind;
ein Terminal, das angepasst ist, um die konstante Hochspannung (VGH) zu empfangen; und
ein Terminal, das angepasst ist, um die konstante Niederspannung (VGL) zu empfangen.

2. Anzeigevorrichtung gemäß Anspruch 1, **dadurch gekennzeichnet, dass** das erste Taktsignal (CKV1) und das zweite Taktsignal (CKV3) Rechteckwellen sind, die ein Tastverhältnis von 0,25 aufweisen, und sich die Wellenformen zwischen dem ersten Taktsignal (CKV1) und dem zweiten Taktsignal (CKV3) um einen Halbzyklus unterscheiden.

3. Anzeigevorrichtung gemäß Anspruch 1 oder 2, **dadurch gekennzeichnet, dass** für die erste GOA-Einheit in der Kaskade, während einer Vorwärtsabtastung, das erste Startsignal auf Hochspannung ist; wenn das erste Startsignal zu Niederspannung wird, das Ausgabesignal (Gn) der nten GOA-Einheit zu Hochspannung wird.

4. Anzeigevorrichtung gemäß einem der Ansprüche 1 bis 3, **dadurch gekennzeichnet, dass** für die letzte GOA-Einheit in der Kaskade, während einer Rückwärtsabtastung, das zweite Startsignal auf Hochspannung ist; wenn das zweite Startsignal zu Niederspannung wird, das Ausgabesignal (Gn) der nten GOA-Einheit zu Hochspannung wird.

5. Anzeigevorrichtung gemäß einem der Ansprüche 1 bis 4, **dadurch gekennzeichnet, dass** für die erste GOA-Einheit in der Kaskade, während einer Vorwärtsabtastung, wenn das erste Startsignal auf Hochspannung ist, das dritte Startsignal auf Hochspannung ist.

6. Anzeigevorrichtung gemäß einem der Ansprüche 1 bis 5, **dadurch gekennzeichnet, dass** für die letzte GOA-Einheit in der Kaskade, während einer Rückwärtsabtastung, wenn das zweite Startsignal auf Hochspannung ist, das vierte Startsignal auf Hochspannung ist.

7. Anzeigevorrichtung gemäß einem der Ansprüche 1 bis 6, **dadurch gekennzeichnet, dass** die GOA-Schaltung für ein Low-Temperature-Polysilicon-Panel, LTPS-Panel, ist.

8. Anzeigevorrichtung gemäß einem der Ansprüche 1 bis 7, **dadurch gekennzeichnet, dass** die GOA-Schaltung für ein Organic-Light-Emitting-Diode-Panel, OLED-Panel, ist.

## Revendications

1. Un dispositif d'affichage comprenant :
un circuit d'attaque de grille sur matrice, GOA (*gate driver on array,* GOA), ledit circuit GOA comprenant une pluralité d'unités GOA en cascade,
un circuit conçu pour fournir une haute tension (VGH) constante et une basse tension (VGL) constante, et
un circuit conçu pour fournir un premier signal d'horloge (CKV1), un deuxième signal d'horloge (CKV3), et des premier à quatrième signaux de départ,
dans lequel, pour un nombre entier positif n, **caractérisé en ce que** la n-ième unité GOA comprend :
un premier transistor en couches minces, TFT (*thin film transistor,* TFT) (T1), ayant une source et un drain connectés respectivement à un premier nœud (H) et à la haute tension (VGH) constante, lorsque la n-ième unité GOA n'est pas la première unité GOA dans la cascade, ayant une grille connectée à une sortie de signal (Gn-1) de la (n-1)ième unité GOA ; autrement, la grille étant connectée au premier signal de départ ;
un troisième TFT (T3), ayant une source et un drain connectés respectivement au premier nœud (H) et à la haute tension (VGH) constante, lorsque la n-ième unité GOA n'est pas la dernière unité GOA dans la cascade, ayant une grille connectée à une sortie de signal (Gn+1) de la (n+1)ième unité GOA ; autrement, la grille étant connectée au deuxième signal de départ ;
un septième TFT (T7), ayant une grille connectée au premier nœud (H), une source et un drain connectés respectivement à un troisième nœud (P) et à la basse tension (VGL) constante ;
un sixième TFT (T6), ayant une grille connectée au troisième nœud (P), une source et un drain connectés respectivement au premier nœud (H) et à la basse tension (VGL) constante ;
un cinquième TFT (T5), ayant une grille connectée à un deuxième terminal d'horloge conçu pour recevoir le deuxième signal d'horloge (CKV3), une source et un drain connectés respectivement au troisième nœud (P) et à la haute tension (VGH) constante ;
un quatrième TFT (T4), ayant une grille connectée au troisième nœud (P), une source et un drain connectés respectivement à une sortie de signal (Gn) de la n-ième unité GOA et à la basse tension (VGL) constante ;
un deuxième TFT (T2), ayant une grille connectée à un deuxième nœud (Qn) de la n-ième unité GOA, une source et un drain connectés respectivement à la sortie de signal (Gn) de n-ième unité GOA et à un premier terminal d'horloge conçu pour recevoir le premier signal d'horloge (CKV1) ;
un huitième TFT (T8), ayant une source et un drain connectés respectivement au premier nœud (H) et au deuxième nœud (Qn) de la n-ième unité GOA, lorsque la n-ième unité GOA n'est pas la première unité GOA dans la cascade, ayant une grille connectée au deuxième nœud (Qn) de (n-1)ième unité GOA ; autrement, la grille étant connectée au troisième signal de départ ;
un neuvième TFT (T9), ayant une source et un drain connectés respectivement au premier nœud (H) et au deuxième nœud (Qn) de n-ième unité GOA, lorsque la n-ième unité GOA n'est pas la dernière unité GOA dans la cascade, ayant une grille connectée au deuxième nœud (Qn) de (n+1)ième unité GOA ; autrement, la grille étant connectée au quatrième signal de départ ;
un premier condensateur (C1), ayant deux extrémités connectées respectivement au deuxième nœud (Qn) de n-ième unité GOA et à la sortie de signal (Gn) de n-ième unité GOA;
un deuxième condensateur (C2), ayant deux extrémités connectées respectivement au troisième nœud (P) et à la basse tension (VGL) constante ;
un terminal conçu pour recevoir la haute tension (VGH) constante ; et
un terminal conçu pour recevoir la basse tension (VGL) constante.

2. Le dispositif d'affichage tel que revendiqué dans la revendication 1, **caractérisé en ce que** le premier signal d'horloge (CKV1) et le deuxième signal d'horloge (CKV3) sont des ondes rectangulaires ayant un facteur de marche de 0,25, et les formes d'onde entre le premier signal d'horloge (CKV1) et le deuxième signal d'horloge (CKV3) diffèrent d'un demi cycle.

3. Le dispositif d'affichage tel que revendiqué dans la revendication 1 ou la revendication 2, **caractérisé en ce que** pour la première unité GOA dans la cascade, durant un balayage avant, le premier signal de départ est à haute tension ; lorsque le premier signal de départ devient basse tension, le signal de sortie (Gn) de n-ième unité GOA devient haute tension.

4. Le dispositif d'affichage tel que revendiqué dans n'importe laquelle des revendications 1 à 3, **caractérisé en ce que** pour la dernière unité GOA dans la cascade, durant un balayage arrière, le deuxième signal de départ est à haute tension ; lorsque le deuxième signal de départ devient basse tension, le signal de sortie (Gn) de n-ième unité GOA devient haute tension.

5. Le dispositif d'affichage tel que revendiqué dans n'importe laquelle des revendications 1 à 4, **caractérisé en ce que** pour la première unité GOA dans la cascade, durant un balayage avant, lorsque le premier signal de départ est à haute tension, le troisième signal de départ est haute tension.

6. Le dispositif d'affichage tel que revendiqué dans n'importe laquelle des revendications 1 à 5, **caractérisé en ce que** pour la dernière unité GOA dans la cascade, durant un balayage arrière, lorsque le deuxième signal de départ est à haute tension, le quatrième signal de départ est haute tension.

7. Le dispositif d'affichage tel que revendiqué dans n'importe laquelle des revendications 1 à 6, **caractérisé en ce que** le circuit GOA est pour un panneau en polysilicium à basse température, LTPS (*low temperature polysilicon,* LTPS).

8. Le dispositif d'affichage tel que revendiqué dans n'importe laquelle des revendications 1 à 7, **caractérisé en ce que** le circuit GOA est pour un panneau à diodes électroluminescentes organiques, OLED (*organic light-emitting diode,* OLED).
